# FASCICULE DE BREVET EUROPEEN

(11) **EP 0 963 598 B1**
(45) Date de publication et mention de la délivrance du brevet: **10.03.2010**
(21) Numéro de dépôt: 98964541.1
(22) Date de dépôt: 29.12.1998
(51) Int. Cl.: H01L 21/265, H01L 21/762

(54) **PROCEDE POUR LE TRANSFERT D'UN FILM MINCE COMPORTANT UNE ETAPE DE CREATION D'INCLUSIONS**
VERFAHREN ZUR ÜBERTRAGUNG EINES DÜNNFILMS MIT EINEM EINSCHLUSSERZEUGUNGSCHRITT
METHOD FOR TRANSFERRING A THIN FILM COMPRISING A STEP OF GENERATING INCLUSIONS

(30) Priorité: 30.12.1997 FR 9716696
(43) Date de publication de la demande: 15.12.1999
(60) Demande divisionnaire: 10152671.3
(73) Titulaire: COMMISSARIAT A L'ENERGIE ATOMIQUE, 75015 Paris (FR)
(72) Inventeur: MORICEAU, Hubert, F-38120 Saint-Egrève (FR); BRUEL, Michel, F-38113 Veurey (FR); ASPAR, Bernard, F-38140 Rives (FR); MALEVILLE, Christophe, F-38360 Noyarey (FR)
(74) Mandataire: Quantin, Bruno Marie Henri
(86) Numéro de dépôt international: PCT/FR1998/002904
(87) Numéro de publication internationale: WO 1999/035674

(56) Documents cités:
- EP-A- 0 533 551
- EP-A- 0 717 437
- EP-A- 0 801 419
- EP-A2- 0 767 486
- SZE S.M.: 'VLSI Technology', 1985, MC GRAW-HILL, SINGAPORE * page 169 *

## Description

### Domaine technique

La présente invention concerne un procédé pour le transfert d'un film mince de matériau solide. Ce procédé permet en particulier le transfert d'un film mince de matériau solide sur un support constitué d'un matériau solide de même nature ou de nature différente.

### Etat de la technique antérieure

Le document FR-A-2 681 472 (correspondant au brevet US-A-5 374 564) décrit un procédé de fabrication de films minces de matériau semiconducteur. Ce document divulgue que l'implantation d'un gaz rare ou d'hydrogène dans un substrat en matériau semiconducteur est susceptible de créer la formation d'une couche de microcavités ou de microbulles (encore désignées par le terme "platelets" dans la terminologie anglo-saxonne) à une profondeur voisine de la profondeur moyenne de pénétration (Rp) des ions implantés. La notion de microcavités inclut bien entendu les microfissures. L'épaisseur de la couche de microcavités est déterminée par les conditions d'implantation. Si ce substrat est mis en contact intime, par sa face implantée avec un raidisseur et qu'un traitement thermique est appliqué à une température suffisante, il se produit une interaction entre les microcavités ou les microbulles conduisant à une séparation du substrat semiconducteur en deux parties : un film mince semiconducteur adhérant au raidisseur d'une part, le reste du substrat semiconducteur d'autre part. La séparation a lieu à l'endroit où les microcavités ou microbulles sont présentes. Le traitement thermique est tel que l'interaction entre les microbulles ou microcavités créées par implantation induit une séparation entre le film mince et le reste du substrat. Il y a donc transfert d'un film mince depuis un substrat initial jusqu'à un raidisseur servant de support à ce film mince.

Ce procédé peut également s'appliquer à la fabrication d'un film mince de matériau solide autre qu'un matériau semiconducteur (un matériau conducteur ou diélectrique), cristallin ou non.

Si le film mince délimité dans le substrat est suffisamment rigide par lui-même (à cause de son épaisseur ou à cause de ses propriétés mécaniques) on peut obtenir, après le recuit de transfert, un film autoporté. C'est ce qu'enseigne le document FR-A-2 738 671.

Il a été proposé, par le document EP-A-O 767 486, une amélioration du procédé divulgué dans le document FR-A-2 681 472 cité plus haut. D'après le document EP-A-O 767 486 (voir la colonne 8), le procédé divulgué par le document FR-A,-2 681 472 présente les inconvénients suivant. Le choix de l'épaisseur du film à transférer est d'un degré de liberté faible. L'épaisseur du film à transférer (correspondant à Rp) et les conditions de séparation du film d'avec le substrat initial sont liées. La planéité de la surface du film obtenu après la séparation n'est pas satisfaisante et il n'est pas possible de conserver l'homogénéité en épaisseur d'un film mince lors du transfert. L'amélioration proposée par le document EP-A-O 767 486 consiste à réaliser l'implantation d'ions à la profondeur Rp dans une couche de silicium poreuse formée à la surface d'un substrat en silicium. Cette implantation ionique provoque une augmentation de la porosité (densité de pores) dans la mesure où apparaissent des microcavités dans les parois des pores de la couche poreuse. Cette couche est alors considérée comme une structure poreuse fine. Sous certaines conditions d'implantation, la séparation est provoquée dans cette couche poreuse fine, conformément au mécanisme décrit dans le document FR-A-2 681 472. Il existe donc deux effets de zone de par une zone de pores créés par une étape de génération de silicium poreux, et de par une zone de cavités générées entre les pores dans les petites zones de silicium parfait comme pour le procédé selon le document FR-A-2 681 472. L'amélioration proposée consiste donc à utiliser une couche poreuse pour obtenir, après séparation, une couche dont l'homogénéité en épaisseur est bien contrôlée.

Le procédé divulgué par le document EP-A-O 767 486 préconise la formation de silicium poreux (la porosité est d'un pourcentage de l'ordre de plusieurs dizaines), ce qui revient à retirer du silicium ou de la matière au niveau de la zone de séparation et ce qui entraîne une fragilisation du matériau.

Une amélioration plus sensible du procédé révélé par le document FR-A-2 681 472 serait de réduire l'épaisseur de la couche de microcavités obtenue par implantation ionique. C'est ce que propose la présente invention.

### Exposé de l'invention

L'amélioration proposée par la présente invention est rendue possible grâce à la création dans le matériau du substrat initial d'une inclusion ou d'un ensemble d'inclusions afin de confiner les espèces gazeuses introduites lors de l'étape d'implantation ionique. Une inclusion est un volume de matériau dont les propriétés sont différentes de celles du matériau du substrat à partir duquel on veut transférer un film mince ou des films minces. Les inclusions peuvent se présenter sous la forme d'une couche s'étendant sensiblement parallèlement à la surface au travers de laquelle on réalise l'implantation. Les formes que peuvent prendre ces volumes sont diverses et leurs dimensions peuvent aller de quelques dixièmes de nanomètres à plusieurs centaines de micromètres.

Le rôle des inclusions est d'être des pièges pour les espèces gazeuses implantées. Le rayon d'action de ces pièges dépend de la nature des inclusions réalisées. Il n'y a pas alors de rentrait de matière, comme dans le cas du procédé divulgué par le document EP-A-O 767 486.

Le procédé selon la présente invention comprend une étape préliminaire consistant à former des inclusions dans le matériau du substrat initial. Une étape postérieure consiste à implanter des espèces gazeuses, de gaz rare ou non, dans ce matériau. La présence des inclusions formées à l'étape précédente entraîne un confinement des espèces gazeuses implantées. L'efficacité des inclusions est liée à leur pouvoir de confinement des espèces gazeuses.

Les inclusions peuvent être formées au voisinage d'une profondeur parfaitement contrôlable. Leur présence induit alors un confinement des espèces implantées dans une couche perturbée d'épaisseur plus fine que celle que l'on obtient dans le procédé de l'art connu. Il en résulte plusieurs avantages. Les espèces gazeuses implantées sont piégées préférentiellement au niveau et/ou dans la zone influencée par ces inclusions, dite voisinage de ces inclusions. Cette localisation précise permet d'induire une fracture de séparation (transfert) au niveau et/ou au voisinage des inclusions. Il en résulte une rugosité relativement faible de la surface au niveau de la fracture. De plus, dû au pouvoir de confinement, un tel procédé permet l'usage de faibles doses implantées nécessaires à la fracture. Enfin, l'effet de confinement par la présence des inclusions permet de diminuer le budget thermique nécessaire à la fracture, dans la mesure où l'on favorise la nucléation et la croissance des cavités amenant à la fracture. L'intérêt est évident dans le cas de transfert de structures en films pour lesquelles une limitation de montée en température existe. On peut citer, comme exemple, le collage hétérogène de matériaux ayant des coefficients de dilatation différents de plus de 10%.

L'invention a donc pour objet un procédé pour le transfert d'au moins un film mince de matériau solide délimité dans un substrat initial, caractérisé en ce qu'il comprend les étapes suivantes :
- une étape de fourniture d'un substrat initial,
- une étape de formation d'une couche d'inclusions dans le substrat initial, à une profondeur correspondant à l'épaisseur désirée pour le film mince, ces inclusions étant prévues pour constituer une zone de confinement pour les espèces gazeuses qui seront ensuite introduites,
- une étape postérieure d'introduction desdites espèces gazeuses, de façon à amener les espèces gazeuses dans la couche d'inclusions, la dose des espèces gazeuses introduit étant suffisante pour provoquer la formation de microcavités susceptibles de constituer un plan de fracture permettant la séparation du film mince du reste du substrat.

L'étape d'introduction des espèces gazeuses peut être réalisée avec une énergie d'introduction de ces espèces gazeuses telle que leur profondeur moyenne de pénétration dans le substrat correspond à la profondeur de la couche d'inclusions. Elle peut aussi être réalisée avec une énergie d'introduction de ces espèces gazeuses telle que leur profondeur moyenne de pénétration dans le substrat est au voisinage de la couche d'inclusions, cette introduction étant associée avec un traitement thermique de diffusion pour permettre la migration des espèces introduites au niveau de la couche d'inclusions.

L'étape d'introduction peut être réalisée à partir d'une ou de plusieurs espèces gazeuses introduites soit simultanément, soit successivement.

Le substrat initial peut être constitué d'une partie massive supportant une structure en film(s) dans laquelle doit être délimité ledit film de matériau solide. Tout ou partie de cette structure peut être obtenu par épitaxie. Cette structure peut être telle que, après transfert du film mince, le reste du substrat, porteur ou non d'une épitaxie, est réutilisable pour un autre transfert de film mince.

La couche d'inclusions peut être formée par implantation d'éléments dans une couche du substrat. Ces éléments peuvent être implantés en une ou plusieurs fois. L'implantation de ces éléments peut être assistée par un traitement thermique apte à augmenter l'efficacité des pièges, ce traitement thermique pouvant être effectué avant, pendant et/ou après l'implantation. Ce traitement thermique est apte à modifier la morphologie et/ou la composition des inclusions, ce qui favorise le confinement ultérieur des espèces gazeuses. Ce traitement thermique est réalisé à une température et pendant une durée telles qu'il ne permet pas de réaliser une fracture sur l'ensemble de la couche d'inclusions.

L'introduction des espèces gazeuses peut être réalisée par l'implantation par bombardement d'espèces choisies parmi les espèces neutres et les ions. Elle peut encore être réalisée par une méthode choisie parmi la diffusion assistée par plasma, la diffusion thermique et la diffusion assistée par plasma combinée avec la diffusion thermique et/ou assistée par polarisation électrique. L'implantation peut être effectuée de façon normale par rapport à la face implantée du substrat, ou avec une certaine incidence. Elle peut être effectuée en utilisant des éléments différents de gaz rares ou non.

Le procédé peut comprendre une étape de traitement thermique apte à fragiliser le substrat au niveau de la couche d'inclusions pour permettre la séparation entre le film mince et le reste du substrat. Ce traitement thermique est mené avec un budget thermique déterminé et qui est fonction des différents budgets thermiques utilisés au cours du procédé. En particulier, ce traitement thermique tient compte du ou des échauffements induits par des traitements thermiques de type hors équilibres thermodynamiques tels que ceux pouvant résulter de l'étape de formation des inclusions et/ou de l'étape d'introduction des espèces gazeuses et par des traitements thermiques utilisant un chauffage ou un refroidissement du substrat, tels que par exemple pour l'implantation, ou un éventuel renforcement de forces de liaison dans le cas du collage avec un support. Ce traitement thermique peut donc être nul si les autres étapes du procédé permettent ladite fragilisation. Il peut être réalisé aussi bien avec une température positive qu'avec une température négative. Selon l'invention, cette fragilisation est telle qu'elle permet la séparation du film mince d'avec le reste du substrat avec ou sans l'utilisation de contraintes mécaniques. Ce traitement thermique peut être réalisé par chauffage impulsionnel afin d'obtenir par exemple une montée rapide en température. Ce chauffage impulsionnel peut être de type RTA ("Rapid Thermal Annealing") ou de type RTP ("Rapid Thermal Process") par exemple.

Le procédé peut comprendre en outre une étape de mise en contact intime du film mince délimité dans le substrat avec un support auquel le film mince adhérera après sa séparation d'avec le reste du substrat. La mise en contact intime peut être réalisée directement (par adhésion moléculaire par exemple) ou par l'intermédiaire d'un matériau rapporté. Une étape de traitement thermique peut être mise en oeuvre pour renforcer l'adhésion entre le film mince délimité dans le substrat et le support rapporté.

Des contraintes mécaniques peuvent être exercées au cours et/ou après et/ou avant le traitement thermique pour contribuer à la séparation entre le film mince et le reste du substrat.

Le procédé selon l'invention s'applique avantageusement au transfert d'un film mince de silicium à partir d'un substrat initial. Il peut s'appliquer aussi au transfert d'un film mince de matériau semiconducteur III-V (par exemple de l'AsGa) à partir d'un substrat initial. Le film mince peut être constitué lui-même d'une structure en films minces. Il peut avoir été au moins partiellement traité avant son transfert pour y constituer, sur tout ou partie du film à transférer, un circuit intégré ou pour y constituer, sur tout ou partie du film à transférer, un composant optoélectronique.

### Brève description des dessins

L'invention sera mieux comprise au moyen de la description qui va suivre, donné à titre d'exemple non limitatif, accompagnée des dessins annexés parmi lesquels
- les figures 1A à 1D sont illustratives du procédé selon l'invention dans le cas où un film mince est transféré sur un raidisseur ;
- la figure 2 est une vue transversale d'un substrat permettant l'obtention d'une structure SOI différente du procédé selon l'invention.

### Description détaillée de modes de réalisation de l'invention

Le substrat à partir duquel sera transféré le film mince peut être un substrat massif (formé d'un matériau unique) ou un substrat composite, c'est-à-dire formé de films de natures chimiques et/ou physiques identiques ou différentes.

Les inclusions peuvent être générées dans le substrat initial en particulier par un changement de nature physique par exemple implantation d'ions divers.

Des inclusions peuvent aussi être générées par implantation ionique.

L'implantation par bombardement d'espèces neutres ou d'ions dans un matériau peut engendrer une couche riche en inclusions, à une profondeur spécifique de l'élément implanté. Pour les espèces implantées, on prend alors en compte les effets de freinage électronique et nucléaire par le matériau cible. Dans le procédé selon l'invention, le matériau initial est considéré comme le matériau cible. Le procédé d'implantation peut être fait d'une ou plusieurs implantations. Ces implantations peuvent éventuellement être assistées pendant ou entre chaque implantation par un traitement thermique. On trouvera les espèces implantées et les défauts associés au voisinage d'une profondeur moyenne de pénétration Rp (nommée "projected range" en anglais). Les inclusions générées apparaissent comme un désordre à petite échelle dans l'ordre local du matériau. Leur morphologie et leur taille peuvent être modifiées par un traitement thermique et/ou une implantation unique et/ou multiple du même élément ou non.

Comme exemple, on peut citer la réalisation de matériau silicium sur isolant (SOI) par le procédé SIMOX (Séparation par IMplantation d'OXygène). L'implantation à 120 keV d'oxygène est suivie d'un traitement thermique à haute température (par exemple environ 1300°C) pour modifier la topologie et la morphologie des inclusions générées. L'implantation à faible dose (environ 4.1017 O/cm2) d'oxygène, dans une plaque de silicium, permet de réaliser une couche d'oxyde à une profondeur typique de 250 nm, de faible épaisseur (typiquement 80 à 100 nm) . Cette couche est défectueuse : elle est plus ou moins continue (présence de canaux de silicium nommés "pipes" en anglais) et elle contient des îlots de silicium (de quelques dizaines de nanomètres comme dimensions typiques), en fonction de la dose implantée. On peut se référer à ce propos à l'article de B. ASPAR et al., intitulé "Ultra Thin Buried Oxide Layers Formed by Low Dose SIMOX Processes", Proc. 6th International Conférence on SOI Technology and Devices, Electroch. Soc., Vol. 94-11 (1994) 62. De même, les interfaces de cette couche d'oxyde avec le film supérieur sont plus ou moins rugueuses en fonction des traitements thermiques imposés. Typiquement, la rugosité d'interface pourra être contrôlée dans une gamme de quelques dixièmes de nanomètres à quelques nanomètres comme cela est mentionné dans l'article intitulé : "Characterization by Atomic Force Microscopy cf the SOI Layer Topography in Low-Dose SIMOX Materials" de C. GUILHALMENC et al., paru dans la revue Materials Science and Engineering B 46 (1997) 29-32. Cette couche implantée et ses interfaces seront considérées comme une zone d'inclusions, zones de confinement pour les espèces gazeuses implantées lors de la seconde étape du procédé selon 1' invention.

Les traitements thermiques peuvent également être utilisés pour générer des inclusions dans le matériau initial, support ou dans une au moins des couches de la structure en filin(s) à transférer.

A titre d'exemple on citera, pour le silicium, les traitements thermiques, dits "high-low-high" en anglais, permettant de faire précipiter, à une certaine profondeur, l'oxygène présent dans le matériau. Cette profondeur est typiquement de quelques micromètres dans le cas du silicium monocristallin obtenu par tirage Czochralski.

Pour cela, un cycle en température sera typiquement constitué d'un palier à haute température, supérieure à 1000°C, suivi d'un palier à basse température, inférieure à 900°C, de nouveau suivi d'un palier à haute température, supérieure à 1000°C. Un ordre de grandeur de la profondeur x peut être évalué à partir de l'équation de diffusion x α(Dt)^{1/2} dans laquelle D est le coefficient de diffusion à la température de traitement thermique et t le temps de la diffusion à cette température. Cette couche générée par des traitements thermiques est considérée comme zone d' 0inclusions.

Le procédé selon l'invention comprend une seconde étape après la génération d'inclusions dans le matériau concerné. Cette seconde étape consiste en une introduction d'espèces gazeuses (atomes, ions) à une profondeur située au voisinage de la couche d'inclusions générées à l'étape précédente. Ces espèces gazeuses sont confinées, grâce à la présence des inclusions. Elles participent à la nucléation et/ou à la croissance de microcavités, microbulles (ou "platelets") nécessaires à la fracture de transfert. Cette introduction peut être réalisée à travers la surface plane de la structure à transférer par bombardement et/ou par diffusion assistée par plasma et/ou par traitement thermique et/ou par polarisation électrique.

Dans le cas d'implantation par bombardement (espèces neutres et/ou ions), ces espèces gazeuses sont implantées à la profondeur moyenne de pénétration, Rp. Cette profondeur est caractéristique de l'énergie d'implantation de l'élément implanté dans une cible donnée. On choisira donc une énergie d'implantation telle que la profondeur Rp correspond au niveau de la zone des inclusions ou telle que la profondeur soit au voisinage de la zone d'inclusions, un traitement thermique de diffusion étant alors utilisé pour permettre la migration des espèces implantées au niveau de la zone des inclusions. Les espèces gazeuses pourront être de gaz rares ou non, telles H, F, He. Elles pourront être implantées simultanément ou successivement.

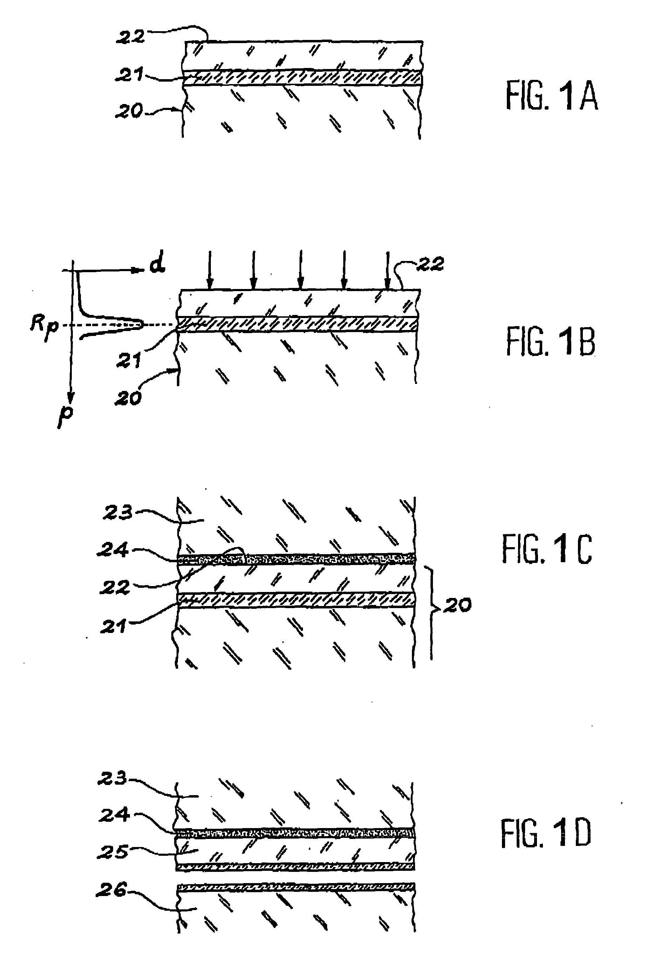

Les figures 1A à 1D illustrent le procédé selon l'invention dans le cas où le film mince est transféré sur un raidisseur. La figure 1A montre un substrat 20 (par exemple formé d'une structure en film(s) mince(s) sur un support initial) comportant une zone d'inclusions 21 formée par l'une des méthodes décrites ci-dessus. La zone d'inclusions est située à une distance de la surface 22 du substrat correspondant à l'épaisseur du film mince à transférer. La figure 1B illustre l'étape d'implantation ionique. Des espèces gazeuses sont implantées, par exemple par bombardement ou par diffusion, au travers de la surface 22 du substrat. La densité d d'espèces gazeuses en fonction de la profondeur p est telle que leur profondeur moyenne Rp de pénétration correspond à la zone d'inclusions 21 qui devient une zone piège, dense en espèces gazeuses. La figure 1C illustre une étape d'adhésion de la surface 22 du substrat 20 à un raidisseur 23 par apport d'une couche intermédiaire 24. D'autres techniques d'adhérence entre la surface 22 et le raidisseur 23, sans apport d'une couche intermédiaire, peuvent aussi être utilisées. La figure 1D illustre l'étape de séparation consécutive à un traitement thermique approprié en fonction du budget thermique requis comme expliqué plus haut. Sur cette figure, la fracture de séparation passe dans la zone de pièges. Le substrat initial est donc partagé en un film mince 25 adhérent au raidisseur 23 et en une partie restante 26. La zone de pièges est montrée ici partagée en deux régions. Cependant, selon les cas, elle peut rester complète en adhérant soit au film mince 25, soit à la partie restante 26 du substrat.

Dans le cas d'implantation par diffusion gazeuse, les espèces peuvent diffuser jusqu'à une profondeur au voisinage de celle des inclusions, en adaptant le temps et la température de diffusion. Les lois de diffusion classiques en (Dt)^{1/2} sont applicables pour adapter la profondeur de diffusion. Ainsi, un traitement thermique sous atmosphère d'argon et d'hydrogène, dans le rapport 9:1 (dit "forming gas" en anglais), permet la diffusion d'hydrogène dans du silicium, à environ 350°C.

Quel que soit le mode d'introduction, les espèces gazeuses doivent être introduit en une quantité suffisante pour participer à la nucléation et/ou au développement de microcavités, microbulles (ou "platelets") à partir et au voisinage des inclusions décrites précédemment. Les conditions d'introduction (dose, énergie, température de cible, temps d'introduction) dépendent en particulier
- du matériau initial (cible),
- de la nature et de la localisation des inclusions,
- du budget thermique fourni par l'introduction,
- de la nature des espèces gazeuses introduites,
- du budget thermique fourni postérieurement à un éventuel collage,
- du budget thermique (énergétique) fourni par le traitement thermique, de fragilisation,
- d'éventuelles contraintes mécaniques.
Les doses introduites sont néanmoins inférieures à la dose maximale, dose définie par l'apparition d'exfoliation dans le matériaux lors de l'introduction des espèces gazeuses. On définit l'efficacité des inclusions par leur pouvoir de confinement des espèces gazeuses nécessaires au transfert, en considérant la concentration de ces espèces au voisinage des inclusions.

Dans le cas d'implantation ionique, cet effet est illustré par une diminution de la largeur du profil d'implantation, due à une concentration plus importante des espèces implantées autour du Rp d'implantation. Comme exemple, on considère une structure à transférer composée d'un film de SiO₂ de 0,4 µm d'épaisseur généré sur un support de silicium. Une première implantation ionique d'hydrogène de 3.10¹⁶ H⁺/cm², à l'énergie de 100 keV, destinée à générer les inclusions, provoquera une concentration d'hydrogène à la profondeur moyenne de 0,9 µm. Un traitement thermique est réalisé, typiquement aux environs de 350°C, pendant 2 heures, et est destiné à modifier la morphologie des inclusions (microcavités). On constate que l'épaisseur de la couche contenant les cavités est plus fine que si l'implantation avait été réalisée avec une dose supérieure comme dans le cas du procédé divulgué par le document FR-A-2 681 472. La zone d'inclusions correspond à cette couche de microcavités en cours de croissance. Une deuxième implantation de 2.10¹⁶ H⁺/cm² sera suffisante pour permettre une fracture, au voisinage de cette zone d'inclusions, lors des traitements thermiques de séparation, par exemple à 500°C pendant 1, heure.

On comprend donc l'avantage d'un confinement et d'une localisation possible des microcavités, microbulles (ou "platelets") sur une épaisseur très fine du fait de l'épaisseur de la zone d'inclusions réalisées et/ou de la structure en films utilisées. De même, la rugosité de la surface de fracture sera également réduite du fait du confinement des inclusions et donc de la zone de fracture.

D'une façon générale, il est alors possible de réduire la dose à implanter, nécessaire à la nucléation et/ou au développement de microcavités et/ou de diminuer les forces à exercer et/ou de réduire le budget énergétique du traitement thermique pour induire la fracture.

Le procédé de transfert visant à obtenir une structure finale en film(s) sur un support suppose que le matériau initial soit rapporté sur un deuxième support au cours d'une troisième étape. La mise en contact est soit directe, par adhésion moléculaire (nominée "wafer bonding" en anglais), soit par l'intermédiaire d'une couche d'adhésion. Elle doit permettre au support final d'avoir un rôle de raidisseur. Dans les deux cas de mise en contact, direct et indirect, une étape de fixation par un traitement thermique à basse température peut être nécessaire. Ce traitement doit être adapté pour ne pas empêcher les mécanismes de croissance des microcavités et de fracture dans le matériau initial. Il sera à prendre en compte dans le budget thermique nécessaire pour induire la fracture lors d'une quatrième étape du procédé. Si la structure à transférer est suffisamment rigide et/ou épaisse et que cette étape n'est pas nécessaire, on obtiendra lors du transfert, une structure dite autoportée.

Ainsi, dans l'exemple d'une structure recouverte d'un film de SiO2 a transférer sur un support de silicium, une température de l'ordre de 200°C sera suffisante pour renforcer l'adhésion moléculaire. L'énergie de collage entre le film d'oxyde et le support de silicium sera supérieure à 0,3 J/m2.

La quatrième étape du procédé de transfert de structures en film(s) nécessite un traitement thermique dont le temps et la température sont définis, en particulier, en fonction de l'efficacité des inclusions créés, de la dose d'espèces gazeuses introduites, des conditions thermiques de l'introduction des espèces gazeuses dans le matériau initial et des conditions thermiques d'adhésion à la plaque support final. Le traitement thermique doit être suffisant pour provoquer une fracture dans le matériau initial. On provoque ainsi une séparation entre une partie du matériau initial non utilisé et la structure en film(s) en contact avec le support final. Cette séparation s'effectue au voisinage de la couche des espèces piégées. Dans les conditions de l'invention, la structure en films (monocouche ou multicouche) peut être transférée avec un budget thermique de fracture réduit en comparaison des budgets thermiques nécessaires dans le procédé selon l'art antérieur. Pour définir le budget thermique de séparation, il faut tenir compte de l'efficacité des inclusions générées et du budget thermique global qui est fourni aux plaques au cours des différentes étapes du procédé, à savoir pendant : la génération des inclusions, l'introduction des espèces gazeuses et l'adhésion du matériau initial sur le support raidisseur.

En outre, une partie de l'énergie nécessaire au transfert des structures peut être apportée par le traitement thermique et/ou à l'aide de contraintes, par exemple : liées à un effet du raidisseur support final, liées à l'application de contraintes de cisaillement, de flexion, de traction, de pression, appliquées seules ou en combinaison. L'effet est de même nature que celui décrit dans le document FR A-2 748 851. Dans ce cas, la dose minimale d'espèces gazeuses à introduire, lors de la seconde étape du procédé, est celle à partir de laquelle il y a une création et/ou une croissance suffisante de microcavités pour induire la fragilisation suffisante de la plaquette parallèlement à la surface.

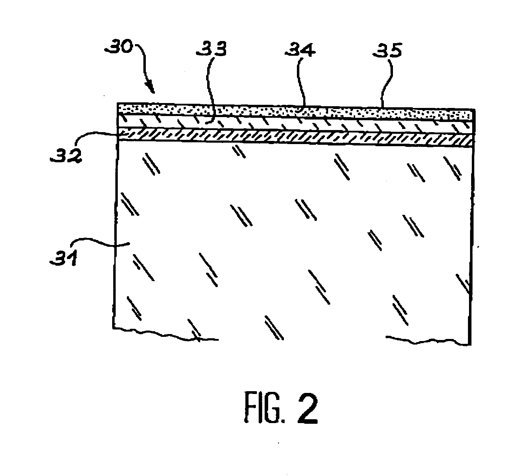

La figure 2 illustre une application différente du procédé selon l'invention à l'obtention d'une structure SOI. Le substrat 30 est formé à partir d'une plaquette de silicium 31 sur une face de laquelle on dépose un film 32 de silicium d'environ 50 nm d'épaisseur, fortement dopé (environ 10¹⁹ atomes/cm3) par du bore, élaboré par épitaxie. Le film 32 est lui-même recouvert d'un film 33 de silicium, d'environ 350 nm d'épaisseur, faiblement dopé (environ 5.10¹⁵ atomes/cm3) par du bore et également élaboré par épitaxie. Le film 33 est enfin recouvert d'un film 34 de SiO2, d'environ 400 nm d'épaisseur et présentant une surface libre 35. Le film 32 de silicium fortement dopé va jouer le rôle de zone d'inclusions.

Le substrat 30 est ensuite soumis à l'étape d'implantation d'espèces gazeuses au travers de la surface 35. On implante de l'hydrogène selon une dose de 5.10¹⁶ atomes/cm2, une énergie de 80 keV et à température ambiante.

La surface 35 est ensuite rendue adhérente à une plaque de silicium, par adhésion moléculaire renforcée par un traitement thermique à 250°C pendant 30 minutes.

L'étape de séparation en deux parties du substrat 30 comporte un traitement thermique dont l'efficacité par rapport à la fracture est adaptée par le budget thermique (durée et température des différents apports thermiques). Ce traitement thermique final permet d'induire une fracture dans le substrat, au niveau et/ou au voisinage du film 32. Le traitement thermique final peut typiquement être de 2 heures à 250°C.

On peut ainsi obtenir une structure formée d'un film de silicium faiblement dopé (le film 33 du substrat) sur une couche d'oxyde de silicium (le film 34 du substrat), celle-ci étant solidaire d'une masse de silicium. Le film 32 de silicium fortement dopé a servi au confinement de la fracture.

Le procédé selon l'invention s'avère particulièrement intéressant dans le cas de transfert de structures dans lesquelles un ou plusieurs films ne doivent pas subir de traitement thermique à une température aussi élevée de celle impliquée dans le procédé divulgué dans le document FR-A-2 681 472. Il est également intéressant à mettre en oeuvre dans le cas où la structure à transférer est constituée de matériaux ayant des coefficients de dilatation thermique différents.

Enfin, il est important de noter l'avantage suivant du procédé selon l'invention. La surface de la structure en film(s) transférée est une zone perturbée, obtenue lors de la fracture. L'épaisseur de cette zone perturbée peut être très réduite du fait de l'utilisation d'une couche au niveau des inclusions pour confiner la dose d'espèces gazeuses introduites. On obtient, ainsi, une rugosité de surface de la structure transférée faible puisque directement liée à la répartition des microcavités ou microbulles, dans l'épaisseur du matériau lors du transfert.

## Revendications

1. Procédé pour le transfert d'au moins un film mince (25) de matériau solide délimité dans un substrat initial (20), le procédé comprenant les étapes suivantes :
- une étape de fourniture d'un substrat initial,
- une étape de formation d'une couche d'inclusions (21) dans le substrat initial, à une profondeur correspondant à l'épaisseur désirée pour le film mince, ces inclusions étant prévues pour constituer une zone de confinement pour les espèces gazeuses, qui seront ensuite introduites, une inclusion étant un volume de matériau dont les propriétés sont différentes de celles du matériau du substrat à partir duquel on veut transférer ledit au moins un film mince,
- une étape postérieure d'introduction desdites espèces gazeuses, de façon à amener les espèces gazeuses dans la couche d'inclusions (21), la dose des espèces gazeuses introduites étant suffisante pour provoquer la formation de microcavités susceptibles de constituer un plan de fracture permettant la séparation du film mince (25) du reste du substrat (20).

2. Procédé pour le transfert d'au moins un film mince selon la revendication 1, **caractérisé en ce que** l'introduction des espèces gazeuses est réalisée par une implantation d'espèces gazeuses.

3. Procédé pour le transfert d'au moins un film mince selon la revendication 2, **caractérisé en ce que** l'étape d'implantation desdites espèces gazeuses est réalisée avec une énergie d'implantation de ces espèces gazeuses telle que leur profondeur moyenne de pénétration dans le Substrat (20) correspond à la profondeur de la couche d'inclusions (21).

4. Procédé pour le transfert d'au moins un film mince selon la revendication 2, **caractérisé en ce que** l'étape d'implantation desdites espèces gazeuses est réalisée avec une énergie d'implantation de ces espèces gazeuses telle que leur profondeur moyenne de pénétration dans le substrat (20) est au voisinage de la couche d'inclusions (21), cette implantation étant associée avec un traitement thermique de diffusion pour permettre la migration des espèces implantées au niveau de la couche d'inclusions (21).

5. Procédé pour le transfert d'au moins un film mince selon l'une quelconque des revendications 1 à 4, **caractérisé en ce que** le substrat initial est constitué d'une partie massive supportant une structuré en film(s) dans laquelle doit être délimité ledit film mince de matériau solide.

6. Procédé pour le transfert d'un film mince selon la revendication 5, **caractérisé en ce que** tout ou partie de ladite structure est obtenu par épitaxie.

7. Procédé pour le transfert d'un film mince selon l'une des revendications 5 ou 6, **caractérisé en ce que** ladite structure est telle que, après transfert dudit film mince, le reste du substrat, porteur ou non d'une couche d'épitaxie, est réutilisable pour un autre transfert de film minces.

8. Procédé pour le transfert d'un film mince selon l'une quelconque des revendications 1 à 7, **caractérisée en ce que** la couche d'inclusions est formée par implantation d'éléments.

9. Procédé pour le transfert d'un film mince selon la revendication 8, **caractérisé en ce que** ladite implantation d'éléments est assistée par un traitement thermique.

10. Procédé pour le transfert d'un film mince selon la revendication 8, **caractérisé en ce que** la morphologie des inclusions est modifiée par un traitement thermique.

11. Procédé pour le transfert d'un film mince selon l'une quelconque des revendications 2 à 10, **caractérisé en ce que** les espèces gazeuses sont choisies parmi les espèces neutres et les ions.

12. Procédé pour le transfert d'un film mince selon la revendication 1, **caractérisé en ce que** l'introduction des espèces gazeuses est réalisée par une méthode choisie parmi la diffusion assistée par plasma, la diffusion thermique et la diffusion assistée par plasma combinée avec la diffusion thermique et/ou assistée par polarisation électrique.

13. Procédé pour le transfert d'un film mince selon l'une quelconque des revendications 1 à 12, **caractérisé en ce qu'**il comprend une étape de traitement thermique apte à fragiliser le substrat au niveau de la couche d'inclusions pour permettre la séparation entre le film mince (25) et le reste du substrat (26).

14. Procédé pour le transfert d'un film mince selon l'une quelconque des revendications 1 à 13, **caractérisé en ce qu'**il comprend en outre une étape de mise en contact intime du film mince (25) délimité dans le substrat avec un support (23) auquel le film mince adhérera après sa séparation d'avec le reste (26) du substrat.

15. Procédé pour le transfert d'un film mince selon la revendication 14, **caractérisé en ce que** ladite mise en contact intime est obtenue par adhésion moléculaire.

16. Procédé pour le transfert d'un film mince selon l'une quelconque des revendications 13 à 15, **caractérisé en ce que** l'étape de traitement thermique apte à fragiliser le substrat est menée par chauffage impulsionnel.

17. Procédé pour le transfert d'un film mince selon l'une quelconque des revendications 1 à 16, **caractérisé en ce qu'**il comprend la mise en oeuvre de contraintes mécaniques pour contribuer à la séparation entre le film mince et le reste du substrat.

18. Application du procédé selon l'une quelconque des revendications 1 à 17 au transfert d'un film mince de silicium à partir d'un substrat initial.

19. Application du procédé selon l'une quelconque des revendications 1 à 17 au transfert d'un film mince de matériau semi-conducteur III-V à partir d'un substrat initial.

20. Application du procédé selon l'une quelconque des revendications 1 à 17 au transfert d'un film mince constitué lui-même d'une structure en films minces.

21. Application du procédé selon l'une quelconque des revendications 1 à 17, **caractérisée en ce que** le film mince a été au moins partiellement traité avant son transfert pout y constituer, sur tout ou partie du film à transférer, un circuit intégré.

22. Application du procédé selon l'une quelconque des revendications 1 à 17, **caractérisée en ce que** le film mince a été au moins partiellement traité avant son transfert pour y constituer, sur tout ou partie du film à transférer, un composant optoélectronique.

## Claims

1. Method for transferring at least one thin film (25) of solid material defined within an initial substrate (20), the method comprising the following steps:
- a step of providing an initial substrate;
- a step of forming a layer of inclusions (21) in the initial substrate, at a depth corresponding to the desired thickness for the thin film, these inclusions being provided so as to constitute a confinement zone for the gaseous species which will then be introduced, an inclusion being a volume of material, the properties of which are different from those of the material of the substrate from which it is desired to transfer said at least one thin film;
- a subsequent step of introducing said gaseous species, so as to bring the gaseous species into the layer of inclusions (21), the dose of gaseous species introduced being sufficient to cause the formation of microcavities capable of constituting a fracture plane allowing the thin film (25) to be separated from the remainder of the substrate (20).

2. Method for transferring at least one thin film according to claim 1, **characterised in that** the introduction of the gaseous species is carried out by an implantation of gaseous species.

3. Method for transferring at least one thin film according to claim 2, **characterised in that** the step of implanting said gaseous species is carried out with an implantation energy of these gaseous species such that their mean depth of penetration into the substrate (20) corresponds to the depth of the layer of inclusions (21).

4. Method for transferring at least one thin film according to claim 2, **characterised in that** the step of implanting said gaseous species is carried out with an implantation energy of these gaseous species such that their mean depth of penetration into the substrate (20) is in the vicinity of the layer of inclusions (21), this implantation being associated with a thermal diffusion treatment in order to allow migration of the implanted species within the layer of inclusions (21).

5. Method for transferring at least one thin film according to any one of claims 1 to 4, **characterised in that** the initial substrate consists of a solid part supporting a film or multifilm structure within which said thin film of solid material must be defined.

6. Method for transferring a thin film according to claim 5, **characterised in that** all or part of said structure is obtained by epitaxy.

7. Method for transferring a thin film according to either of claims 5 and 6, **characterised in that** said structure is such that, after said thin film has been transferred, the rest of the substrate, which may or may not carry an epitaxial layer, can be reused for another thin-film transfer.

8. Method for transferring a thin film according to any one of claims 1 to 7, **characterised in that** the layer of inclusions is formed by implantation of elements.

9. Method for transferring a thin film according to claim 8, **characterised in that** said implantation of elements is assisted by a heat treatment.

10. Method for transferring a thin film according to claim 8, **characterised in that** the morphology of the inclusions is modified by a heat treatment.

11. Method for transferring a thin film according to any one of claims 2 to 10, **characterised in that** the gaseous species are chosen from neutral species and ions.

12. Method for transferring a thin film according to claim 1, **characterised in that** the introduction of the gaseous species is carried out by a method chosen from plasma-assisted diffusion, thermal diffusion and plasma-assisted diffusion combined with thermal diffusion and/or diffusion assisted by electrical polarization.

13. Method for transferring a thin film according to any one of claims 1 to 12, **characterised in that** it includes a heat treatment step capable of embrittling the substrate at the layer of inclusions in order to allow the thin film (25) to be separated from the remainder (26) of the substrate.

14. Method for transferring a thin film according to any one of claims 1 to 13, **characterised in that** it furthermore includes a step of bringing the thin film (25) defined in the substrate into intimate contact with a support (23) to which the thin film will bond after it has been separated from the remainder (26) of the substrate.

15. Method for transferring a thin film according to claim 14, **characterised in that** said intimate contact is obtained by molecular bonding.

16. Method for transferring a thin film according to any one of claims 13 to 15, **characterised in that** the heat treatment step capable of embrittling the substrate is carried out by pulse heating.

17. Method for transferring a thin film according to any one of claims 1 to 16, **characterised in that** it includes the use of mechanical stresses to help to separate the thin film from the remainder of the substrate.

18. Application of the method according to any one of claims 1 to 17 to transferring a thin silicon film from an initial substrate.

19. Application of the method according to any one of claims 1 to 17 to transferring a thin film of III-V semiconductor material from an initial substrate.

20. Application of the method according to any one of claims 1 to 17 to transferring a thin film consisting itself of a thin-film structure.

21. Application of the method according to any one of claims 1 to 17, **characterised in that** the thin film has been at least partly treated before its transfer in order to constitute an integrated circuit thereon, over all or part of the film to be transferred.

22. Application of the method according to any one of claims 1 to 17, **characterised in that** the thin film has been at least partly treated before its transfer in order to constitute an optoelectronic component thereon, over all or part of the film to be transferred.

## Patentansprüche

1. Verfahren zum Übertragen mindestens eines in einem Ausgangssubstrat (20) abgegrenzten Dünnfilms (25) aus einem festem Werkstoff, wobei das Verfahren die folgenden Schritte umfasst:
- einen Schritt des Lieferns eines Ausgangssubstrats,
- einen Schritt der Bildung einer Schicht von Einschlüssen (21) in dem Ausgangssubstrat in einer Tiefe, die der für den Dünnfilm gewünschten Dicke entspricht, wobei diese Einschlüsse vorgesehen sind, um eine Einschließungszone für die gasförmigen Spezies zu bilden, die dann eingeführt werden, wobei ein Einschluss ein Werkstoffvolumen ist, dessen Eigenschaften von denjenigen des Werkstoffs des Substrats verschieden sind, von dem aus man den mindestens einen Dünnfilm übertragen möchte,
- einen späteren Schritt der Einführung der gasförmigen Spezies, so dass die gasförmigen Spezies in die Schicht von Einschlüssen (21) gebracht werden, wobei die Dosis der eingeführten gasförmigen Spezies ausreichend ist, um die Bildung von Mikrohohlräumen zu verursachen, die in der Lage sind, eine Bruchebene zu bilden, die die Trennung des Dünnfilms (25) vom Rest des Substrats (20) gestattet.

2. Verfahren zum Übertragen mindestens eines Dünnfilms nach Anspruch 1, **dadurch gekennzeichnet, dass** die Einführung der gasförmigen Spezies durch Implantation von gasförmigen Spezies vorgenommen wird.

3. Verfahren zum Übertragen mindestens eines Dünnfilms nach Anspruch 2, **dadurch gekennzeichnet, dass** der Schritt der Implantation der gasförmigen Spezies mit einer solchen Energie der Implantation dieser gasförmigen Spezies vorgenommen wird, dass ihre mittlere Eindringtiefe in dem Substrat (20) der Tiefe der Schicht von Einschlüssen (21) entspricht.

4. Verfahren zum Übertragen mindestens eines Dünnfilms nach Anspruch 2, **dadurch gekennzeichnet, dass** der Schritt der Implantation der gasförmigen Spezies mit einer solchen Energie der Implantation dieser gasförmigen Spezies vorgenommen wird, dass ihre mittlere Eindringtiefe in dem Substrat (20) in Nähe der Schicht von Einschlüssen (21) liegt, wobei diese Implantation mit einer Diffusionswärmebehandlung kombiniert ist, um das Wandern der implantierten Spezies auf Höhe der Schicht von Einschlüssen (21) zu gestatten.

5. Verfahren zum Übertragen mindestens eines Dünnfilms nach einem der Ansprüche 1 bis 4, **dadurch gekennzeichnet, dass** das Ausgangssubstrat aus einem massiven Teil besteht, der eine Film(e)-Struktur trägt, in der der Dünnfilm aus festem Werkstoff abgegrenzt werden soll.

6. Verfahren zum Übertragen eines Dünnfilms nach Anspruch 5, **dadurch gekennzeichnet, dass** die ganze Struktur oder ein Teil davon durch Epitaxie erhalten wird.

7. Verfahren zum Übertragen eines Dünnfilms nach einem der Ansprüche 5 oder 6, **dadurch gekennzeichnet, dass** die Struktur so beschaffen ist, dass nach Übertragung des Dünnfilms der Rest des Substrats, der eine Epitaxieschicht trägt oder nicht, für eine andere Dünnfilmübertragung wiederverwendbar ist.

8. Verfahren zum Übertragen eines Dünnfilms nach einem der Ansprüche 1 bis 7, **dadurch gekennzeichnet, dass** die Schicht von Einschlüssen durch Implantation von Elementen gebildet wird.

9. Verfahren zum Übertragen eines Dünnfilms nach Anspruch 8, **dadurch gekennzeichnet, dass** die Implantation von Elementen durch eine Wärmebehandlung unterstützt wird.

10. Verfahren zum Übertragen eines Dünnfilms nach Anspruch 8, **dadurch gekennzeichnet, dass** die Morphologie der Einschlüsse durch eine Wärmebehandlung modifiziert wird.

11. Verfahren zum Übertragen eines Dünnfilms nach einem der Ansprüche 2 bis 10, **dadurch gekennzeichnet, dass** die gasförmigen Spezies aus den neutralen Spezies und den Ionen ausgewählt sind.

12. Verfahren zum Übertragen eines Dünnfilms nach Anspruch 1, **dadurch gekennzeichnet, dass** die Einführung der gasförmigen Spezies durch eine Methode vorgenommen wird, die ausgewählt ist aus der durch Plasma gestützten Diffusion, der thermischen Diffusion und der durch Plasma gestützten Diffusion kombiniert mit der thermischen und/oder durch elektrische Polarisation gestützten Diffusion.

13. Verfahren zum Übertragen eines Dünnfilms nach einem der Ansprüche 1 bis 12, **dadurch gekennzeichnet, dass** es einen Schritt der Wärmebehandlung umfasst, der geeignet ist, das Substrat auf Höhe der Schicht von Einschlüssen zu fragilisieren, um die Trennung zwischen dem Dünnfilm (25) und dem Rest (26) des Substrats zu gestatten.

14. Verfahren zum Übertragen eines Dünnfilms nach einem der Ansprüche 1 bis 13, **dadurch gekennzeichnet, dass** es außerdem einen Schritt des innigen In-Kontakt-Bringens des in dem Substrat abgegrenzten Dünnfilms (25) mit einem Träger (23) umfasst, an dem der Dünnfilm nach seiner Trennung von dem Rest (26) des Substrats haften wird.

15. Verfahren zum Übertragen eines Dünnfilms nach Anspruch 14, **dadurch gekennzeichnet, dass** das innige In-Kontakt-Bringen durch molekulare Adhäsion erhalten wird.

16. Verfahren zum Übertragen einer Dünnschicht nach einem der Ansprüche 13 bis 15, **dadurch gekennzeichnet, dass** der Schritt der Wärmebehandlung, der geeignet ist, das Substrat zu fragilisieren, durch Impulserhitzung vorgenommen wird.

17. Verfahren zum Übertragen eines Dünnfilms nach einem der Ansprüche 1 bis 16, **dadurch gekennzeichnet, dass** es den Einsatz von mechanischen Beanspruchungen umfasst, um zur Trennung zwischen dem Dünnfilm und dem Rest des Substrats beizutragen.

18. Anwendung des Verfahrens nach einem der Ansprüche 1 bis 17 auf das Übertragen eines Silicium-Dünnfilms ausgehend von einem Ausgangssubstrat.

19. Anwendung des Verfahrens nach einem der Ansprüche 1 bis 17 auf das Übertragen eines Dünnfilms aus III-V-Halbleitermaterial ausgehend von einem Ausgangssubstrat.

20. Anwendung des Verfahrens nach einem der Ansprüche 1 bis 17 auf die Übertragung eines Dünnfilms, der seinerseits aus einer Dünnfilme-Struktur besteht.

21. Anwendung des Verfahrens nach einem der Ansprüche 1 bis 17, **dadurch gekennzeichnet, dass** der Dünnfilm vor seiner Übertragung mindestens teilweise behandelt wurde, um darin, auf dem ganzen zu übertragenden Film oder einem Teil davon, eine integrierte Schaltung zu bilden.

22. Anwendung des Verfahrens nach einem der Ansprüche 1 bis 17, **dadurch gekennzeichnet, dass** der Dünnfilm vor seiner Übertragung mindestens teilweise behandelt wurde, um darin auf dem ganzen Film oder einem Teil davon ein optoelektronisches Bauelement zu bilden.
